(19) Europäisches Patentamt
European Patent Office
Office européen des brevets

(11) **EP 4 491 922 A1**

(12) **EUROPEAN PATENT APPLICATION**
published in accordance with Art. 153(4) EPC

(43) Date of publication:
**15.01.2025 Bulletin 2025/03**

(21) Application number: **23766546.8**

(22) Date of filing: **21.02.2023**

(51) International Patent Classification (IPC):
**F16K 17/38** (2006.01)    **F16K 17/40** (2006.01)

(52) Cooperative Patent Classification (CPC):
**F16K 17/38; F16K 17/40**

(86) International application number:
**PCT/JP2023/006326**

(87) International publication number:
**WO 2023/171368 (14.09.2023 Gazette 2023/37)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **09.03.2022 JP 2022036686**

(71) Applicant: **Nippon Kayaku Kabushiki Kaisha
Tokyo 100-0005 (JP)**

(72) Inventors:
• **HATANAKA, Tomohiro
  Himeji-shi, Hyogo 679-2123 (JP)**
• **SASAMOTO, Kouichi
  Himeji-shi, Hyogo 679-2123 (JP)**
• **SAEKI, Nobuyuki
  Himeji-shi, Hyogo 679-2123 (JP)**

(74) Representative: **Gille Hrabal
Partnerschaftsgesellschaft mbB
Patentanwälte
Brucknerstraße 20
40593 Düsseldorf (DE)**

(54) **SAFETY VALVE FOR HIGH-PRESSURE TANK**

(57)    Provided is a safety valve capable of discharging a predetermined amount of gas from the beginning of activation.

A safety valve 30 includes a main body 31 and an igniter 34 (an example of an opening means). The main body 31 includes a region 31A that is a male threaded portion, an internal space 31B in which the igniter 34 is provided, a bore 31C that communicates with a space 10a of a tank body 10, an openable portion 32 that is a bottom portion of the bore 31C and that is opened (a hole is formed by melting, cleavage, breakage, or the like) when the igniter 34 is ignited, and a discharge port 33 that communicates with an external environment and discharges gas at the time of activation. The total opening area of the discharge port 33 is preferably 0.008 to 5.5 (mm$^2$).

FIG.1

EP 4 491 922 A1

**Description**

TECHNICAL FIELD

The present invention relates to a safety valve for a high-pressure tank.

BACKGROUND ART

Some high-pressure tanks (gas cylinders) accommodating compressed gas and the like are equipped with a safety valve (also referred to as a fusible plug valve) having a structure in which a fusible plug is melted and opened when an ambient temperature abnormally rises for some reason. For example, in a case where the temperature of the high-pressure tank abnormally rises due to a fire or the like, it is possible to prevent the high-pressure tank from bursting due to the activation of the safety valve.

CITATIONS LIST

PATENT LITERATURE

Patent Literature 1: JP 5007809 B2

SUMMARY OF INVENTION

TECHNICAL PROBLEMS

In the safety valve (fusible plug valve) of Patent Literature 1, it takes time until the fusible plug is completely melted, and thus it is difficult to constantly discharge the gas from the beginning of activation. Note that, in a case where combustible gas (for example, hydrogen gas or the like) is accommodated in the high-pressure tank, it is preferable to be able to discharge the gas having, for example, a small degree of influence even if the hydrogen gas is ignited) for a predetermined time from the beginning of the activation of the safety valve.

Therefore, an object of the present invention is to provide a safety valve capable of discharging a predetermined amount (for example, an amount of influence is small even if ignition occurs) of gas from the beginning of the activation.

SOLUTIONS TO PROBLEMS

(1) The present invention is a safety valve for a high-pressure tank that can be connected to an opening of a tank body filled with a fluid inside, the safety valve including: a main body including a discharge port that comes into contact with an external environment, and a flow path that allows the opening and the external environment to communicate with each other via the discharge port; and a valve that is provided at any position of the flow path, closes the flow path at a normal time, and opens the flow path at a time of abnormally high temperature or abnormality detection, in which a total opening area of the discharge port is 0.008 to 5.5 ($mm^2$).
(2) In the safety valve for a high-pressure tank of (1) described above, it is preferable that the valve includes an openable portion that is opened by driving of an opening means provided in the flow path, and the opening means is provided downstream of the openable portion in the flow path, and opens the openable portion using energy (heat, pressure, etc.) obtained by ignition of an explosive as a drive source. The term "explosive" as used herein refers to an explosive composition such as an ignition charge, an ignition agent, an AI agent, or a gas generating agent, or an explosive article in which the explosive composition is incorporated into an igniter or a gas generator.
(3) As another point of view, in the safety valve for a high-pressure tank of (2) described above, the opening means may be an igniter that is activated by a flow of a current as the explosive, and the openable portion may include: a cylinder provided in a direction intersecting the flow path; and a piston member that is slidably provided in the cylinder, closes the flow path in an initial state, and slides by a propulsive force obtained by ignition of the igniter when the igniter operates to open the flow path.
(4) In the safety valve for a high-pressure tank of (2) described above, it is preferable that the openable portion is a plate-shaped member that closes the flow path, and the plate-shaped member is melted, broken, or cleaved by energy obtained by ignition of the explosive.
(5) In the safety valve for a high-pressure tank of (2) or (3) described above, it is preferable that the opening means further includes an auto-ignition agent that automatically ignites at a predetermined temperature or higher that is lower than an ignition temperature of the explosive to ignite the explosive.

(6) In the safety valve for a high-pressure tank of (5) described above, the openable portion is preferably formed of a metal soluble at the time of the abnormally high temperature.

(7) As another point of view, the safety valve for a high-pressure tank of (2) described above may include: a power generation unit that generates power by a Seebeck effect in a case where a temperature difference occurs at a predetermined location; and a wiring that electrically connects an igniter that is activated by a flow of a current as the explosive and the power generation unit.

(8) In the safety valve for a high-pressure tank of (7) described above, it is preferable that the power generation unit is formed by electrically connecting one end portion of a first semiconductor and one end portion of a second semiconductor having a Seebeck coefficient different from a Seebeck coefficient of the first semiconductor in series, a protection unit that protects internally a side of another end portion of each of the first semiconductor and the second semiconductor from heat such that a temperature gradient occurs between a side of the one end portion and a side of the other end portion of each of the first semiconductor and the second semiconductor at the time of the abnormally high temperature, and the side of the other end portion of each of the first semiconductor and the second semiconductor is electrically connected to the igniter via the wiring.

(9) As another point of view, in the safety valve for a high-pressure tank of (7) described above, the power generation unit may be formed by layering two or more kinds of materials having different Seebeck coefficients among a metal and a semiconductor in layers, and one side of a layer stack of the power generation unit may be protected from heat by a protection unit such that a temperature gradient occurs in a layering direction in the power generation unit at the time of the abnormally high temperature.

(10) As another point of view, in the safety valve for a high-pressure tank of (7) described above, the power generation unit may be formed of one kind of metal, and may be disposed such that a temperature gradient occurs between a part and a part different from the part at the time of the abnormally high temperature. Here, the shape of the power generation unit includes, for example, a layered shape, a plate shape, a rod shape, a linear shape, a combination of these shapes, and the like.

(11) As another point of view, in the safety valve for a high-pressure tank of (7) described above, the power generation unit may include at least a first metal member and a second metal member having a Seebeck coefficient different from a Seebeck coefficient of the first metal member, and may be formed by electrically connecting one end portion of the first metal member and one end portion of the second metal member, and sides of other end portions of the first metal member and the second metal member may be electrically connected to the igniter via the wiring, and may be disposed such that a temperature gradient occurs between both the end portions.

(12) As another point of view, in the safety valve for a high-pressure tank of (2) described above, the opening means may include a moving body including a protrusion that is fired toward the openable portion by a pressure wave obtained by ignition of the explosive, and when activated, may break or cleave the openable portion with the protrusion of the moving body to open the openable portion.

ADVANTAGEOUS EFFECTS OF INVENTION

According to the present invention, it is possible to provide a safety valve for a high-pressure tank, the safety valve being capable of smoothly discharging a predetermined amount (for example, an amount of influence is small even if hydrogen gas is ignited) of gas from the beginning of operation.

BRIEF DESCRIPTION OF DRAWINGS

FIG. 1 is a partially sectional schematic view of a high-pressure tank including a safety valve according to a first embodiment of the present invention.
FIG. 2 is a partially sectional schematic view illustrating the safety valve of FIG. 1.
FIG. 3 is a partially sectional schematic view illustrating a safety valve according to a second embodiment of the present invention.
FIG. 4 is a partially sectional schematic view illustrating a safety valve according to a third embodiment of the present invention.
FIG. 5 is a partially sectional schematic view illustrating a safety valve according to a fourth embodiment of the present invention.
FIG. 6 is a partially sectional schematic view illustrating a safety valve according to a fifth embodiment of the present invention.
FIG. 7 is a partially sectional schematic view illustrating a safety valve according to a sixth embodiment of the present invention.

FIG. 8 is a partially sectional schematic view illustrating a safety valve according to a seventh embodiment of the present invention.

FIG. 9 is a partially sectional schematic view illustrating a safety valve according to an eighth embodiment of the present invention.

FIG. 10 is a partially sectional schematic view illustrating a safety valve according to a ninth embodiment of the present invention.

FIG. 11 is a partially sectional schematic view of a safety valve according to a tenth embodiment of the present invention.

FIG. 12 is a partially sectional schematic view of a safety valve according to an eleventh embodiment of the present invention.

FIG. 13 is a schematic view of a vehicle to which a high-pressure tank including a safety valve according to a twelfth embodiment of the present invention is attached.

DESCRIPTION OF EMBODIMENTS

<First embodiment>

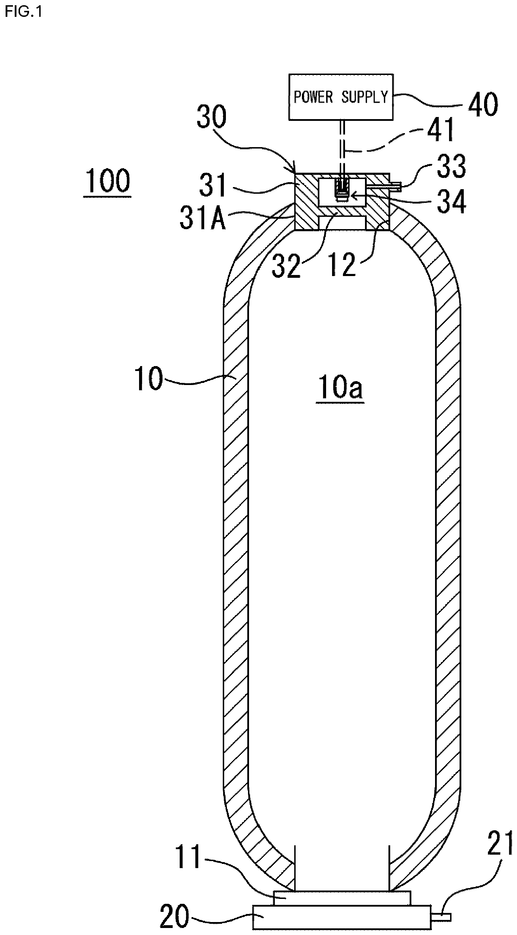

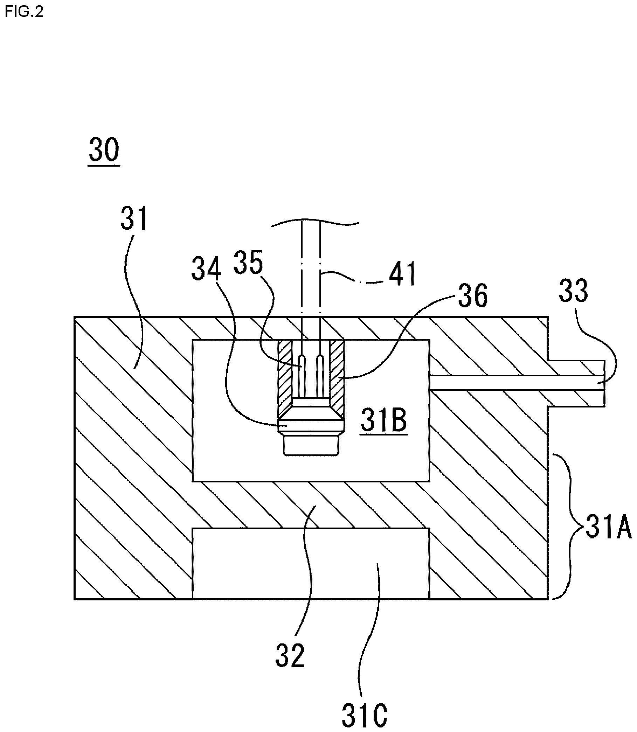

Hereinafter, a first embodiment of the present invention will be described in detail with reference to FIGS. 1 and 2. The present invention can be implemented in various forms without departing from the gist thereof. For example, in the following embodiments, a case where the present invention is applied to a high-pressure tank or the like of fuel gas (high-pressure hydrogen) mounted on a fuel cell vehicle is exemplified, but the present invention is not limited thereto, and can be applied to a high-pressure tank that accommodates another type of compressed gas or liquefied gas.

As illustrated in FIG. 1, a high-pressure tank 100 includes a tank body 10 provided with a space 10a for filling and storing a high-pressure gas (for example, hydrogen gas) therein, an opening 11 provided at one end (lower end in FIG. 1) of the tank body 10, and an opening 12 provided at the other end (upper end in FIG. 1) of the tank body 10.

A cap member (not illustrated) is provided in the opening 11, and a valve (tank valve) 20 is attached to the cap member. The valve 20 is provided with a supply port 21 for supplying gas. For example, a pipe (not illustrated) connected to an engine using hydrogen as a power source such as a fuel cell or a hydrogen engine is connected to the supply port 21, and the gas in the space 10a of the tank body 10 is supplied to the engine using hydrogen as a power source via the valve 20, the supply port 21, and the pipe in a normal state (in a case where a high-temperature abnormality or the like due to a fire does not occur).

A female screw (not illustrated) is cut in the opening 12, and a male screw (not illustrated) provided on a part of an outer peripheral portion of a safety valve 30 on a side of the tank body 10 (a male screw portion 31A on the side of the tank body 10 of an outer peripheral portion of a main body 31 to be described later) is screwed into the opening 12, whereby the safety valve 30 is mounted.

The safety valve 30 includes the main body 31 and an igniter 34(An example of an opening means that is provided on a downstream side of a gas flow with respect to an openable portion 32 with a side of the tank body 10 as an upstream side in a flow path to be described later and opens the openable portion 32 using energy obtained by driving (activation) as a drive source). The main body 31 includes: a male screw portion 31A that is a portion with a male screw; an internal space 31B in which the igniter 34 is provided; a bore 31C that communicates with the space 10a of the tank body 10; the openable portion 32 that is a bottom portion of the bore 31C and is opened (in which a hole is formed by melting, cleavage, breakage, or the like) when the igniter 34 is ignited; and a discharge port 33 that communicates with an external environment and discharges gas at the time of activation.

Here, in a case where the space 10a of the tank body 10 is filled with hydrogen gas, it is preferable to use a material with measures against hydrogen embrittlement for the main body 31, and for example, it is preferable to use SUS316, SUS316L, or the like.

Furthermore, in the openable portion 32, a weak member such as a cut groove may be formed at a position where flame from the igniter 34 hits. As a result, cleavage can be facilitated, and scattered substances can be suppressed. Furthermore, the openable portion 32 may be formed to have a plate thickness that is not deformed by an in-tank gas pressure in a normal state and is cleaved in a case where the igniter 34 is activated. Furthermore, although the openable portion 32 is integrally formed with the main body 31, the openable portion 32 is not limited thereto, and a through hole may be provided, a rupture disk may be provided so as to close the through hole, and the rupture disk may be cleaved by the activation of the igniter 34.

A size of the total opening area varies depending on a critical constant ($\sigma$), a gas constant (R), a temperature (T), a pressure (P) in the tank, a gas capacity (V) in the tank, and a gas discharge time (t). The general formula is as follows.

[Mathematical formula 1]

$$A = \frac{V\sqrt{RT}}{t\sigma P}$$

However, the capacity in the tank that can be technically stored is determined, and it is difficult to produce a minute total opening area also in terms of processing technique. Furthermore, in the case of a minute total opening area, the discharge port may be blocked by foreign matter or the like, and the effect of discharging the gas may not be achieved. Furthermore, in a case where the total opening area is set to a certain value or more, there is a risk that the risk of ignition, detonation, and the like increases as the discharge speed of the gas increases and the high-concentration gas and oxygen in the air are mixed. In order to discharge the gas at an appropriate speed in consideration of these comprehensively, the total opening area of the discharge port 33 is preferably 0.008 to 5.5 $(mm^2)$, and more preferably 0.08 to 3.2 $(mm^2)$.

Furthermore, it is preferable that the discharge port 33 is provided toward the ground side, or a pipe is further attached so that the gas is discharged to the ground side. As a result, even if hydrogen gas is ignited, it is possible to discharge an amount with a small degree of influence (an amount with which damage to people, facilities, and the like is less likely to occur) from the discharge port 33, and it is possible to relatively smoothly discharge the hydrogen gas. Therefore, even if high-temperature abnormality or the like occurs due to fire, it is possible to achieve both prevention of burst of the tank body 10 and reduction of the degree of influence due to ignition of the discharged hydrogen gas.

A fixing member 36 is fixed to an external environment side (upper side in FIG. 2) of the internal space 31B, and fixes and holds the igniter 34.

The igniter 34 is for generating flame, and includes an ignition portion (not illustrated) and a pair of terminal pins 35. The ignition portion includes, in its inside, an ignition charge that ignites and burns at the time of activation to generate flame, and a resistor for igniting the ignition charge.

More specifically, the ignition portion includes a squib cup formed in a cup shape, and an embolus that closes an opening end of the squib cup and holds the squib cup through which the pair of terminal pins 35 is inserted. A resistor (bridge wire) is attached so as to connect tips of the pair of terminal pins 35 inserted into the squib cup, and an ignition charge is loaded in the squib cup so as to surround the resistor or to be close to the resistor. In addition to the ignition charge, an ignition agent and/or an AI agent can also be loaded into the squib cup as necessary.

Here, a nichrome wire or the like is generally used as the resistor, and ZPP (zirconium/potassium perchlorate), ZWPP (zirconium/tungsten/potassium perchlorate), an ignition charge (basic copper nitrate, zirconium) lead tricinate, or the like is generally used as the ignition charge. Note that, as a booster that emits a large amount of flame, a composition including metal powder/oxidant typified by $B/KNO_3$, $B/NaNO_3$, $Sr(NO_3)_2$, or the like, a thermite composition, a composition including titanium hydride/potassium perchlorate, or a composition including titanium/potassium perchlorate is used as the ignition agent, and a composition including B/5-aminotetrazole/potassium nitrate/molybdenum trioxide or 5-aminotetrazole/potassium nitrate/molybdenum trioxide or 5-aminotetrazole/potassium nitrate/strontium nitrate/molybdenum trioxide, which contains 5-aminotetrazole/potassium trioxide as a main component, or a composition including 3-nitro-1,2,4-triazol-5-one/sodium nitrate, or a fumeless powder containing nitrocellulose as a main component, or the like is used as the AI agent. Furthermore, the squib cup and embolus described above are generally made of metal or plastic.

The pair of terminal pins 35 is connected to the ignition portion in order to ignite the ignition charge, and is connected to a power supply 40 (battery or the like) via a wiring 41. For example, the power supply 40 receives a command signal transmitted from a control unit (not illustrated) in a case where a temperature detected by a temperature sensor (not illustrated) that detects an external temperature of the tank body 10 becomes higher than or equal to a predetermined value, and causes a predetermined amount of current to flow through the pair of terminal pins 35 via the wiring 41. That is, when the predetermined amount of current flows through the resistor, Joule heat is generated in the resistor, and the ignition charge starts combustion. A high temperature flame resulting from the combustion ruptures the squib cup accommodating the ignition charge. The time from when the current flows through the resistor to when the igniter 34 is activated is generally 2 [ms] or less in a case where a nichrome wire is used as the resistor.

Next, the operation of the safety valve 30 in the high-pressure tank 100 in the present embodiment will be described.

Referring to FIG. 1, in a case where the high-pressure tank 100 is exposed to an abnormally high temperature of a predetermined temperature or more, the temperature is detected by the above-described temperature sensor, and based on this, a current flows from the power supply 40 to the igniter 34 that is a drive source via the wiring 41 in accordance with a command from the above-described control unit, and the igniter 34 is activated. The openable portion 32 is opened (A hole is formed by melting, cleavage, breakage, or the like) by the flame generated by the activation of the igniter 34, and the internal space 31B and the bore 31C communicate with each other. As the internal space 31B and the bore 31C communicate with each other, the gas filled in the space 10a of the tank body 10 is discharged to the external environment through a flow path formed by the bore 31C, the internal space 31B, and the discharge port 33.

According to the safety valve 30 having the above configuration, a predetermined amount (For example, an amount of influence is small even if ignition occurs) of gas can be discharged from the beginning of activation.

In particular, in the case of use in the high-pressure tank 100 filled with hydrogen gas, by setting a diameter of 0.001 mm to 0.2 mm, and more preferably a diameter of 0.01 mm to 0.1 mm at the discharge port 33, it is possible to discharge an amount with a small degree of influence from the discharge port 33 even if the hydrogen gas is ignited, and it is possible to relatively smoothly discharge the hydrogen gas. Therefore, even if a high-temperature abnormality or the like occurs due to a fire, it is possible to achieve both prevention of a burst in the tank body 10 and to reduce the degree of influence due to the ignition of the discharged hydrogen gas.

<Second embodiment>

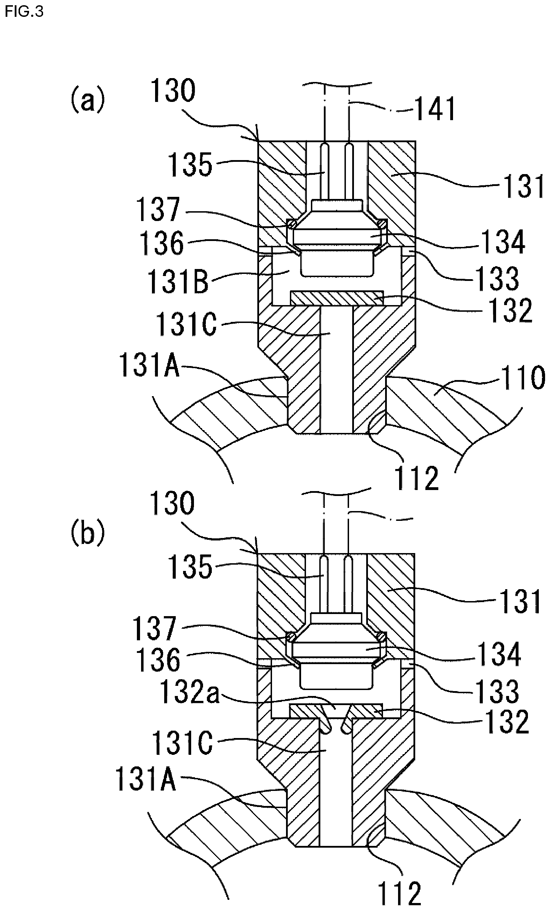

Next, a second embodiment of the present invention will be described in detail with reference to FIG. 3. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

As illustrated in FIG. 3(a), a safety valve 130 is different from the safety valve 30 of the first embodiment mainly in that a main body 131 has an elongated shape as a whole with respect to the main body 31 of the first embodiment, that an openable portion 132, which is a bottom portion that closes a bore 131C, is formed by welding, caulking, cutting, or sticking a plate-shaped member, that one or a plurality of discharge ports 133 is formed, that an igniter 134 is caulked and fixed or molded by a fixing member 136, and that a gap between the main body 131 and the igniter 134 is sealed by an O-ring 137.

Since a part of the openable portion 132 is exposed to compressed gas for a long period of time, the openable portion 132 desirably includes a nickel alloy member formed of a thin metal plate. For example, a thin plate made of metal having heat resistance and corrosion resistance (for example, a thickness of about 200 [$\mu$m]) is suitably used as the openable portion 132, and a thin plate made of stainless steel such as SUS316 or SUS316L (JIS standard symbol) including Ni: 10 [% by weight], Cr: 23 [% by weight], Mn: 6 [% by weight], Mo: 2 [% by weight], C: 0.01 [% by weight], N: 0.5 [% by weight], and other component ratios, or an Inconel alloy (Inconel 625) or the like is particularly suitably used. Furthermore, in the openable portion 132, a weak member such as a cut groove may be formed at a position where flame from the igniter 134 hits.

Note that, among the plurality of discharge ports 133, those that can be provided toward a ground side may be left as they are, but it is preferable to attach a pipe to those that cannot be provided toward the ground side so that the gas is discharged to the ground side. In the case of a structure in which exhaust gas is not combusted or a heat shielding structure or a flame shielding structure in order to prevent flame from damaging others even when the exhaust gas is combusted, the gas do not need to be discharged to the ground side.

Next, an operation of the safety valve 130 in the present embodiment will be described.

Referring to FIG. 3, in a case where the high-pressure tank is exposed to an abnormally high temperature of a predetermined temperature or more, the temperature is detected by a temperature sensor, and based on this, a current flows from a power supply (not illustrated) to the igniter 134 via a wiring 141 in accordance with a command from the above-described control unit, and the igniter 134 is activated. The openable portion 132 is opened (a hole 132a is formed by melting, cleavage, breakage, or the like) by the flame generated by the activation of the igniter 134, and an internal space 131B and the bore 131C communicate with each other (see FIG. 3(b)). As the internal space 131B and the bore 131C communicate with each other, the gas filled in the internal space of the tank body 110 is discharged to the external environment through a flow path formed by the bore 131C, the hole 132a, the internal space 131B, and the discharge ports 133.

According to the safety valve 130 having the above configuration, the effects similar to those of the first embodiment can be obtained.

<Third embodiment>

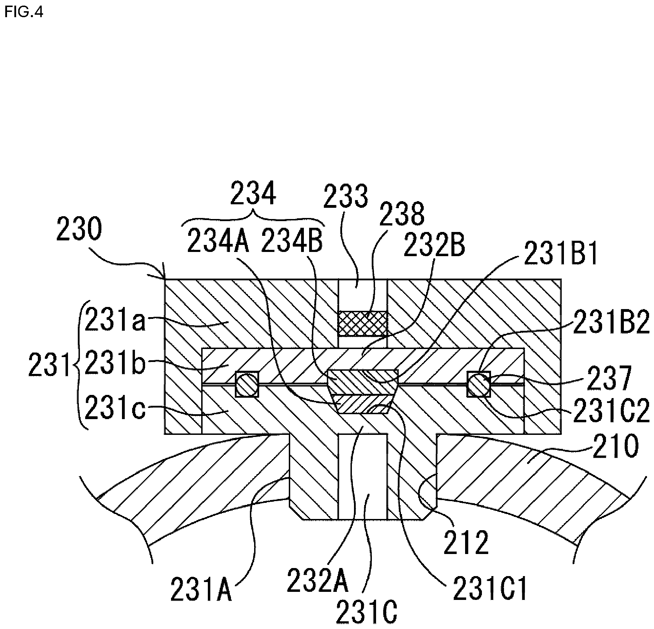

Next, a third embodiment of the present invention will be described in detail with reference to FIG. 4. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

As illustrated in FIG. 4, a safety valve 230 is mainly different from the safety valve 30 of the first embodiment in that a main body 231 including a plurality of members is used, an ignition charge 234A and an auto-ignition agent (AI agent) 234B are used as an opening means 234 instead of the igniter, and a filter 238 is provided in a discharge port 233.

The main body 231 includes a first member 231a having a recessed cross section, a second member 231b having a substantially plate shape, and a third member 231c having a substantially T-shaped cross section. A discharge port 233 is formed in a central portion of the first member 231a. A recess 231B1 is formed on a side of the third member 231c of a central portion of the second member 231b, and a recess 231C1 is formed on a side of the second member 231b of a central portion of the third member 231c. Between the recess 231B1 and the recess 231C1, the ignition charge 234A disposed on a side of the recess 231C1 and the AI agent 234B disposed on a side of the recess 231B1 are sandwiched. The ignition charge 234A and the AI agent 234B may be disposed on either side of the recess 231C1, and further, the ignition charge 234A may be included in the AI agent 234B, and further, the AI agent 234B alone may be used. Furthermore, ring-shaped recesses 231B2 and 231C2 for disposing a seal member 237 between the second member 231b and the third member 231c are provided on opposing surfaces of the second member 231b and the third member 231c, respectively.

The seal member 237 is, for example, an O-ring, a packing, a gasket, or the like. As a material of the seal member 237, fluororubber, styrene-based rubber, olefin-based rubber, or the like may be used. As another aspect, a method of applying an adhesive to the seal member 237 for sealing may be used. As the adhesive, for example, an adhesive containing a cyanoacrylate-based resin, a silicone-based resin, a styrene-based rubber, an olefin-based rubber, or the like as a raw material can be suitably used. Furthermore, the seal member 237 may be made of metal containing at least one of stainless steel, copper, a copper alloy, aluminum, and an aluminum alloy.

Examples of the ignition charge 234A include ZPP (zirconium/potassium perchlorate), ZWPP (zirconium/tungsten/potassium perchlorate), lead tricinate, and the like.

The AI agent 234B is an explosive having an auto-ignition (AI) function of automatically igniting in response to heat due to a temperature in a case where the temperature is higher than or equal to a predetermined temperature that is lower than an ignition temperature of the ignition charge. Here, the AI agent 234B is preferably one that automatically ignites at a temperature lower than a temperature at which the high-pressure tank bursts, for example, an ignition temperature of 230°C or lower, and is preferably one that automatically ignites at 200°C or lower in consideration of a thermal conductivity and a distance of the heat source. Note that, for example, the AI agent 234B preferably includes the following components (A) or (B).

(A) It is an AI agent formed by bonding and molding a fuel component, an oxidant, and a combustion modifier by a binder. Here, examples of the fuel component include a nitrogen atom-containing organic substance including aminotetrazole or a salt thereof. Examples of the oxidant include those in which 50 wt% or more of the oxidant contains nitrate. Examples of the combustion modifier include molybdenum, iron, or oxides thereof. Examples of the binder include those selected from the group of the following (1), (2), and (3).

(1) Hydrotalcite type compound represented by the following general formula $[M^{2+}_{1-x}M^{3+}_x(OH)_2]^{x+}[A^{n-}_{x/n}\cdot mH_2O]^{x-}$ Here, $M^{2+}$: divalent metal such as $Mg^{2+}$, $Mn^{2+}$, $Fe^{2+}$, $Co^{2+}$, $Ni^{2+}$, $Cu^{2+}$, or $Zn^{2+}$ $M^{3+}$: trivalent metal such as $Al^{3+}$, $Fe^{3+}$, $Cr^{3+}$, $Co^{3+}$, or $In^{3+}$ $A^{n-}$: $OH^-$, $F^-$, $Cl^-$, $Br^-$, $NO_3^-$, $CO_3^{2-}$, n-valent anions such as $SO_4^{2-}$, $Fe(CN)_6^{3-}$, $CH_3COO^-$, oxalate ions, and salicylate ions x: $0 < x \leq 0.33$
(2) Acidic clay
(3) Polymer binder

The polymer binder can improve breaking strength and other mechanical properties when the explosive is formed into a desired molded body. Specific examples of the polymer binder include metal salts of carboxymethyl cellulose, hydroxyethyl cellulose, hydroxypropyl methyl cellulose, cellulose acetate, cellulose propionate, cellulose acetate butyrate, nitrocellulose, guar gum, polyvinyl alcohol, polyacrylamide, polysaccharide derivatives such as starch, and organic binders such as stearate, fluororubber, and SBS rubber. These polymer binders may be used singly or in combination of two or more kinds thereof.

(B) (a) The AI agent contains each component of 5-aminotetrazole 3 to 25 (wt%), (b) boron 5 to 30 (wt%), (c) potassium nitrate 50 to 85 (wt%), and (d) molybdenum trioxide 0.2 to 10 (wt%) at each composition ratio, and has a calorific value of 4500 J/g or more.

Next, an operation of the safety valve 230 in the present embodiment will be described.

Referring to FIG. 4, in a case where the high-pressure tank is exposed to an abnormal high temperature higher than or equal to a predetermined temperature that is lower than a temperature at which the high-pressure tank bursts, the AI agent 234B reacts to heat due to the temperature, and automatically ignites, and the ignition charge 234A burns, so that the opening means 234 is activated. Due to the flame generated by the activation of the opening means 234, openable portions 232A and 232B are opened (a hole is formed at the bottom of each of the recess 231B1 and the recess 231C1 by melting, cleavage, breakage, or the like), and the discharge port 233 and a bore 231C communicate with each other. As the discharge port 233 and the bore 131C communicate with each other, the gas filled in the internal space of a tank body 210 is discharged to the external environment through a flow path formed by the bore 131C, the hole formed at the bottom of the recess 231C1, the recess 231C1, the recess 231B1, the hole formed at the bottom of the recess 231B1, and the discharge port 233. Note that, in the discharge port 233, the filter 238 may be disposed as necessary. The filter 238 has a function of collecting residues generated when the ignition charge 234A and the AI agent 234B are burned, and taking heat of the generated gas to cool or extinguish the gas.

With the above configuration, the actions and effects similar to those of the first embodiment can be achieved. Furthermore, since an external power supply such as the power supply 40 is not required, it is possible to reduce the weight of the safety valve 230 as compared with the case of using the safety valve 30 of the first embodiment. Furthermore, even in a state where no current is supplied to control or a sensor such as when a vehicle is stopped, it is possible to detect a fire (detect an abnormality) and safely operate the safety valve.

<Fourth embodiment>

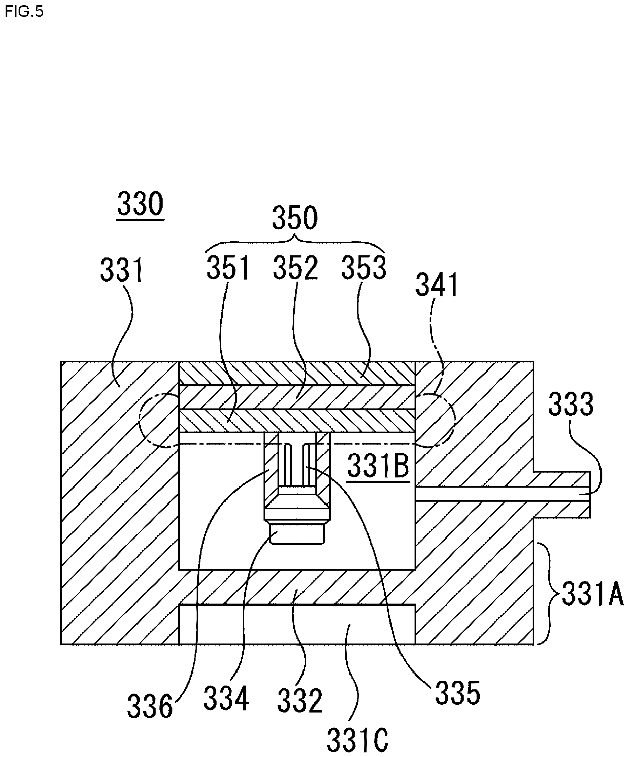

Next, a fourth embodiment of the present invention will be described in detail with reference to FIG. 5. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

As illustrated in FIG. 5, a safety valve 330 is mainly different from the safety valve 30 of the first embodiment in that a power generation unit 350 is used as a current supply source to an igniter 334, a wiring 341 for transmitting a current generated in the power generation unit 350 is provided, and a fixing member 336 is provided inside the power generation unit 350.

The power generation unit 350 includes an inner first metal layer 351, an intermediate semiconductor layer 352, and an outer second metal layer 353, and the semiconductor layer 352 is sandwiched between the first metal layer 351 and the second metal layer 353. Note that the power generation unit 350 is formed by layering two or more kinds of materials having different Seebeck coefficients among semiconductors in layers, and may be of any type as long as it can generate a current in a case of being exposed to an abnormal high temperature of a predetermined temperature or more. Note that the Seebeck coefficient generally refers to a proportional coefficient between a temperature difference and a voltage, in which a voltage proportional to the temperature difference is generated when the temperature difference is generated at both ends of a metal and a semiconductor. Here, examples of the combination of two types of semiconductors include an n-type semiconductor and a p-type semiconductor. Furthermore, in a case where two or more kinds of metals and semiconductors are selected, for example, materials having different Seebeck coefficients are appropriately selected from the materials listed in the following two kinds of combinations of metals and the above two kinds of combinations of semiconductors. Examples of the two kinds of combinations of metals include iridium and rhodium, platinum and rhodium, copper and constantan, iron and constantan, copper and iron, gold and platinum, nickel and molybdenum, tungsten and rhenium, gold and palladium, platinum and palladium, and the like. Furthermore, the power generation unit 350 may be made of only one kind of metal from which the Seebeck effect can be obtained by being disposed so that a temperature difference (temperature gradient) occurs between an outside side and an inside side in a case where the outside has an abnormally high temperature.

Next, an operation of the safety valve 330 in the present embodiment will be described.

Referring to FIG. 5, in a case where the high-pressure tank is exposed to an abnormally high temperature higher than or equal to a predetermined temperature, a current flows from the power generation unit 350 to the igniter 334 via the wiring 341, and the igniter 334 is activated. An openable portion 332 is opened (A hole is formed by melting, cleavage, breakage, or the like) by the flame generated by the activation of the igniter 334, and an internal space 331B and a bore 331C communicate with each other. As the internal space 331B and the bore 331C communicate with each other, the gas filled in the tank body is discharged to the external environment through a flow path formed by the bore 331C, the internal space 331B, and a discharge port 333.

With the above configuration, the actions and effects similar to those of the first embodiment can be achieved. Furthermore, since an external power supply such as the power supply 40 is not required, it is possible to reduce the weight of the safety valve 330 as compared with the case of using the safety valve 30 of the first embodiment. Furthermore, even in a state where no current is supplied to control or a sensor such as when a vehicle is stopped, it is possible to detect a fire (detect an abnormality) and safely operate the safety valve.

<Fifth embodiment>

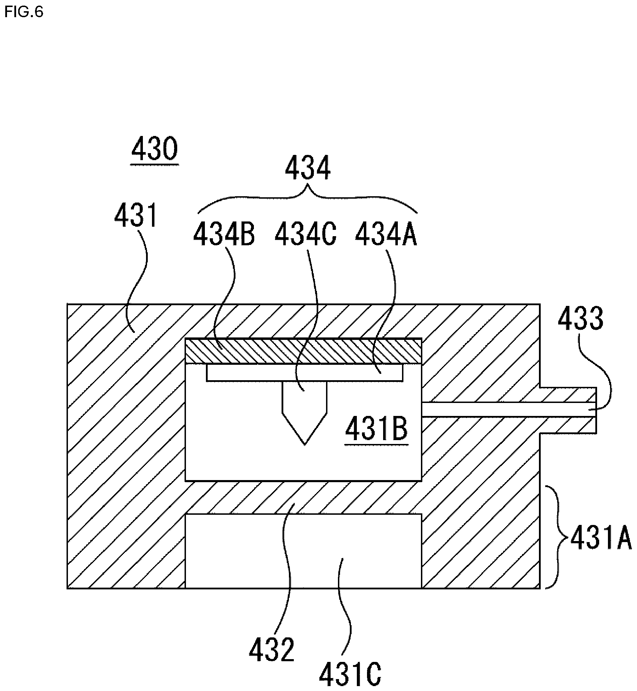

Next, a fifth embodiment of the present invention will be described in detail with reference to FIG. 6. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

As illustrated in FIG. 6, a safety valve 430 is mainly different from the safety valve 30 of the first embodiment in that an opening means 434 is used instead of the igniter.

The opening means 434 includes a plate-shaped pedestal 434A and a pin member 434C (protrusion) having a piston function, and an AI agent 434B. The plate-shaped pedestal 434A is attached to a side of an openable portion 432 of the AI agent 434B. The pin member 434C is fixed to the side of the openable portion 432 of the plate-shaped pedestal 434A, and is a member having a pointed tip.

Next, an operation of the safety valve 430 in the present embodiment will be described.

Referring to FIG. 6, in a case where the high-pressure tank is exposed to an abnormal high temperature higher than or equal to a predetermined temperature that is lower than a temperature at which the high-pressure tank bursts, the AI agent 434B automatically ignites in response to heat due to the temperature. Due to a pressure wave (including static pressure and dynamic pressure) generated by automatic ignition of the AI agent 434B, the plate-shaped pedestal 434A moves to a side of the openable portion 432, the openable portion 432 is opened (a hole is formed by cleavage, breakage, or the like) by the pin member 434C, and an internal space 431B and a bore 431C communicate with each other. As the internal space 431B and the bore 431C communicate with each other, the gas filled in the tank body is discharged to the external environment through a flow path formed by the bore 431C, the internal space 431B, and a discharge port 433.

With the above configuration, the actions and effects similar to those of the first embodiment can be achieved. Furthermore, since an external power supply such as the power supply 40 is not required, it is possible to reduce the weight of the safety valve 430 as compared with the case of using the safety valve 30 of the first embodiment. Furthermore, even in a state where no current is supplied to control or a sensor such as when a vehicle is stopped, it is possible to detect a fire (detect an abnormality) and safely operate the safety valve.

<Sixth embodiment>

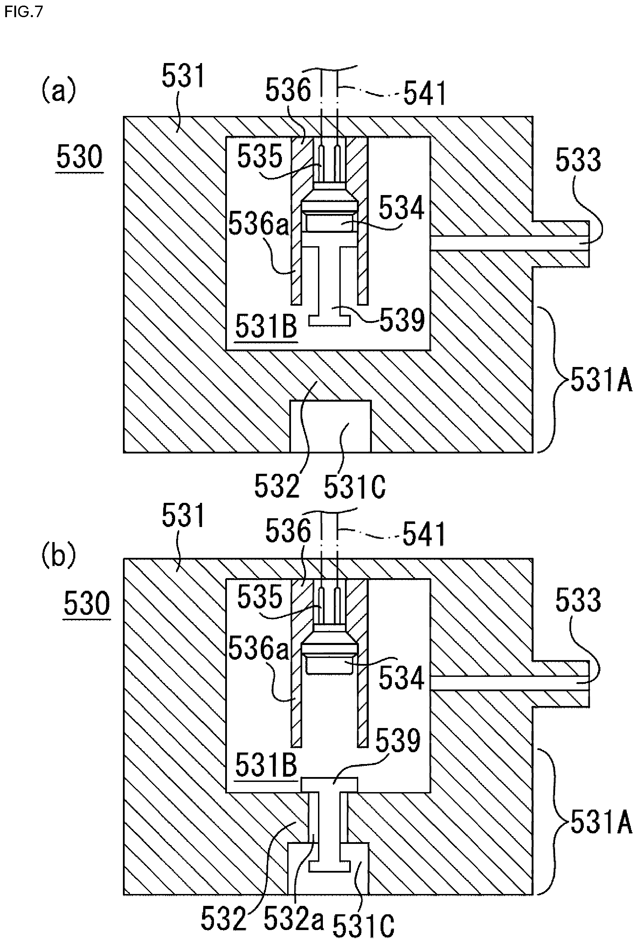

Next, a sixth embodiment of the present invention will be described in detail with reference to FIG. 7. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

As illustrated in FIG. 7, a safety valve 530 is different from the safety valve 30 of the first embodiment mainly in that a fixing member 536 including a cylinder portion 536a is used, and a piston member 539 (moving body) disposed in the cylinder portion 536a is used.

Next, an operation of the safety valve 530 in the present embodiment will be described.

Referring to FIG. 7, in a case where the high-pressure tank is exposed to an abnormally high temperature of a predetermined temperature or more, the temperature is detected by a temperature sensor (not illustrated), and based on this, a current flows from a power supply (not illustrated) to an igniter 534 via a wiring 541 in accordance with a command from the above-described control unit, and the igniter 534 is activated. The piston member 539 slides inside the cylinder portion 536a toward an openable portion 532 by a pressure wave (including static pressure and dynamic pressure) generated by the activation of the igniter 534. Thereafter, the openable portion 532 is opened (a hole 532a is formed by cleavage, breakage, or the like) by a distal end portion of the piston member 539, and an internal space 531B and a bore 531C communicate with each other (see FIG. 7(b)). As the internal space 531B and the bore 531C communicate with each other, the gas filled in the tank body is discharged to the external environment through a flow path formed by the bore 531C, the internal space 531B, and a discharge port 533.

With the above configuration, the actions and effects similar to those of the first embodiment can be achieved.

<Seventh embodiment>

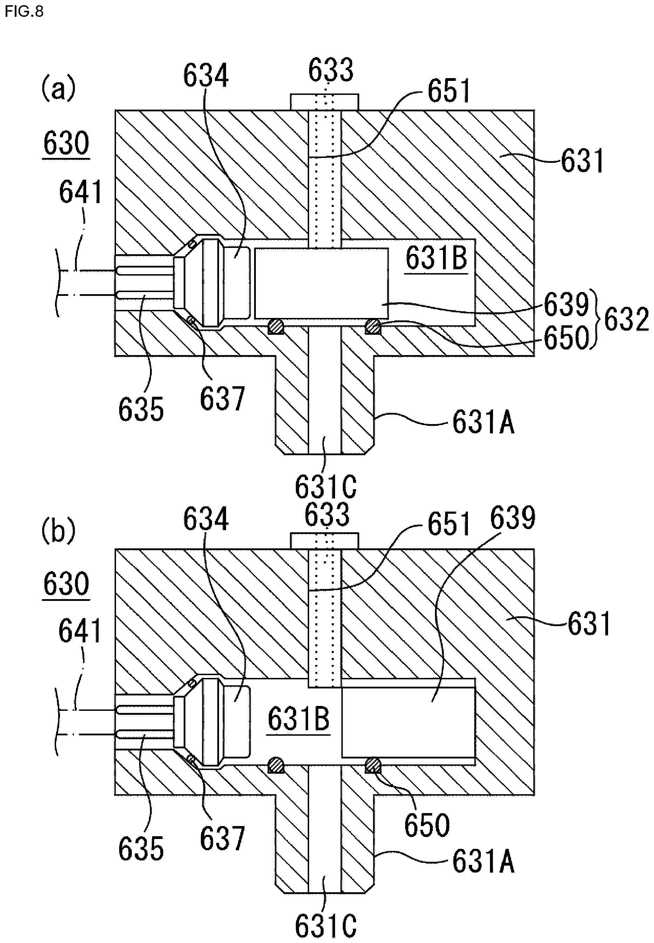

Next, a seventh embodiment of the present invention will be described in detail with reference to FIG. 8. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

As illustrated in a diagram of an initial state of FIG. 8(a), a safety valve 630 is mainly different from the safety valve 30 of the first embodiment in that an openable portion 632, which is a bottom portion that closes a bore 631C, is formed by closing using a plane (lower surface of FIG. 8(a)) of a piston member 639 and a seal member 650, and the piston member 639 (moving body) slides in an internal space 631B by a pressure wave (including static pressure and dynamic pressure) at the time of activation of an igniter 634. Note that, as illustrated in FIG. 8(a), the piston member 639 is pressed against a side of the seal member 650 by a bolt member 660 screwed into a through hole 651, so that high-pressure gas can be sufficiently sealed, and the internal space 631B and the bore 631C do not communicate with each other in the initial state. Furthermore, a discharge port 633 communicating with the outside is formed inside the bolt member 660, and in a case where the piston member 639 is in a state of FIG. 8(b), the internal space 631B and the outside communicate with each other via the discharge port 633.

Next, an operation of the safety valve 630 in the present embodiment will be described.

Referring to FIG. 8, in a case where the high-pressure tank is exposed to an abnormally high temperature of a predetermined temperature or more, the temperature is detected by a temperature sensor (not illustrated), and based on this, a current flows from a power supply (not illustrated) to the igniter 634 via a wiring 641 in accordance with a command from the above-described control unit, and the igniter 634 is activated. The piston member 639 slides in the internal space 631B to a side opposite to the igniter 634 by a pressure wave (including static pressure and dynamic pressure) generated by the activation of the igniter 634. As a result, the openable portion 632 formed by the piston member 639 and the seal member 650 is opened, and the internal space 631B and the bore 631C communicate with each other (see FIG. 8(b)). As the internal space 631B and the bore 631C communicate with each other, the gas filled in the tank body is discharged to the external environment through a flow path formed by the bore 631C, the internal space 631B, and the discharge port 633.

With the above configuration, the actions and effects similar to those of the first embodiment can be achieved.

<Eighth embodiment>

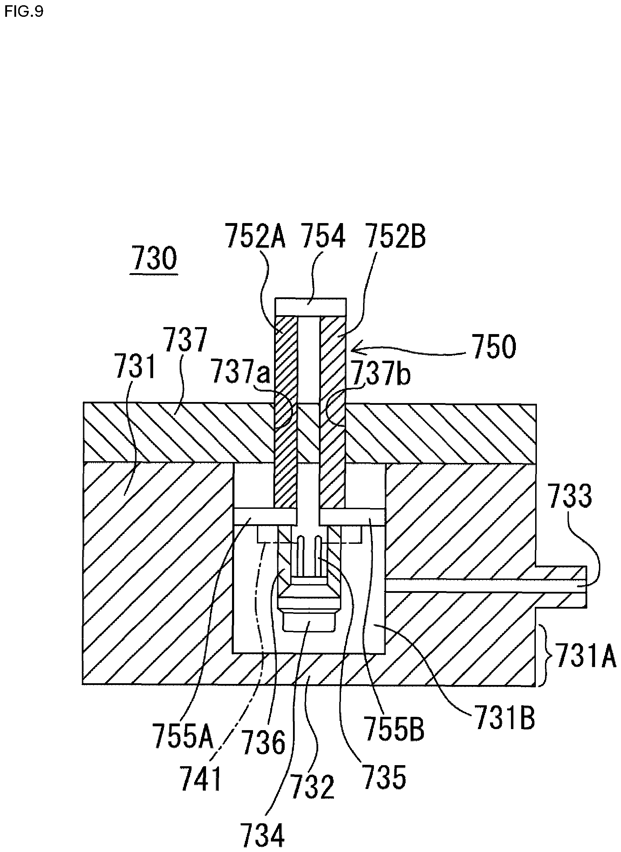

Next, an eighth embodiment of the present invention will be described in detail with reference to FIG. 9. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

As illustrated in FIG. 9, a safety valve 730 is mainly different from the safety valve 30 of the first embodiment in that a power generation unit 750 is used as a current supply source to an igniter 734, a wiring 741 for transmitting a current generated in the power generation unit 750 is provided, a fixing member 736 is provided in a part of the power generation unit 750 to support the igniter 734, and an internal space 731B is formed by a main body 731 and a lid portion 737.

The power generation unit 750 includes a first semiconductor 752A, a second semiconductor 752B, and conductive members 754, 755A, and 755B. For example, the first semiconductor 752A is an n-type semiconductor, and the second semiconductor 752B is a p-type semiconductor.

One end portion (outer end portion) of the first semiconductor 752A and one end portion (outer end portion) of the second semiconductor 752B are electrically connected via the conductive member 754. Furthermore, the other end portion of the first semiconductor 752A is electrically connected to one terminal pin 735 via the conductive member 755A and one wiring 741. Furthermore, the other end portion of the second semiconductor 752B is electrically connected to the other terminal pin 735 via the conductive member 755B and the other wiring 741. Each of the conductive member 755A and the conductive member 755B is fixed to an inner wall of the main body 731 in a state of being electrically insulated from the main body 731 by an adhesive such as resin.

The internal space 731B is formed by being surrounded by the main body 731 including a recess at a center, and the lid portion 737 provided to close the recess. Furthermore, the main body 731 and the lid portion 737 also function as a protection unit that protects sides of the other ends (sides towards the igniter 734) of the first semiconductor 752A and the second semiconductor 752B from external heat.

Furthermore, the first semiconductor 752A and the second semiconductor 752B of the power generation unit 750 are provided so as to pass through through holes 737a and 737b provided in the lid portion 737, respectively. Note that, although not illustrated, the through holes 737a and 737b are closed by the first semiconductor 752A, the second semiconductor 752B, resin, and the like so as not to leak gas. Furthermore, the first semiconductor 752A and the second semiconductor 752B are electrically insulated from the through holes 737a and 737b.

The igniter 734 is supported by the fixing member 736 fixed to a side of the igniter 734 of the conductive members 755A and 755B.

Next, an operation of the safety valve 730 in the present embodiment will be described.

Referring to FIG. 9, in a case where the high-pressure tank is exposed to an abnormal high temperature higher than or equal to a predetermined temperature, a temperature difference occurs between outer portions of the first semiconductor 752A and the second semiconductor 752B and portions on a side of the internal space 731B of the first semiconductor 752A and the second semiconductor 752B, a current flows from the power generation unit 750 to the igniter 734 via the wiring 741 due to the Seebeck effect, and the igniter 734 is activated. An openable portion 732 is opened (A hole is formed by melting, cleavage, breakage, or the like) by the flame generated by the activation of the igniter 734, and the gas filled in the tank body is discharged to the external environment through a flow path formed by the internal space 731B and a discharge port 733. Note that a filter circuit using a transistor protection circuit, a diode, or the like may be connected between the wiring 741 and the igniter 734 as necessary for the purpose of cutting off a current less than or equal to a certain current value. Accordingly, malfunction in an unintended situation can be prevented.

With the above configuration, the actions and effects similar to those of the first embodiment can be achieved. Furthermore, since an external power supply such as the power supply 40 is not required, it is possible to reduce the weight of the safety valve 730 as compared with the case of using the safety valve 30 of the first embodiment. Furthermore, even in a state where no current is supplied to control or a sensor such as when a vehicle is stopped, it is possible to detect a fire (detect an abnormality) and safely operate the safety valve.

<Ninth embodiment>

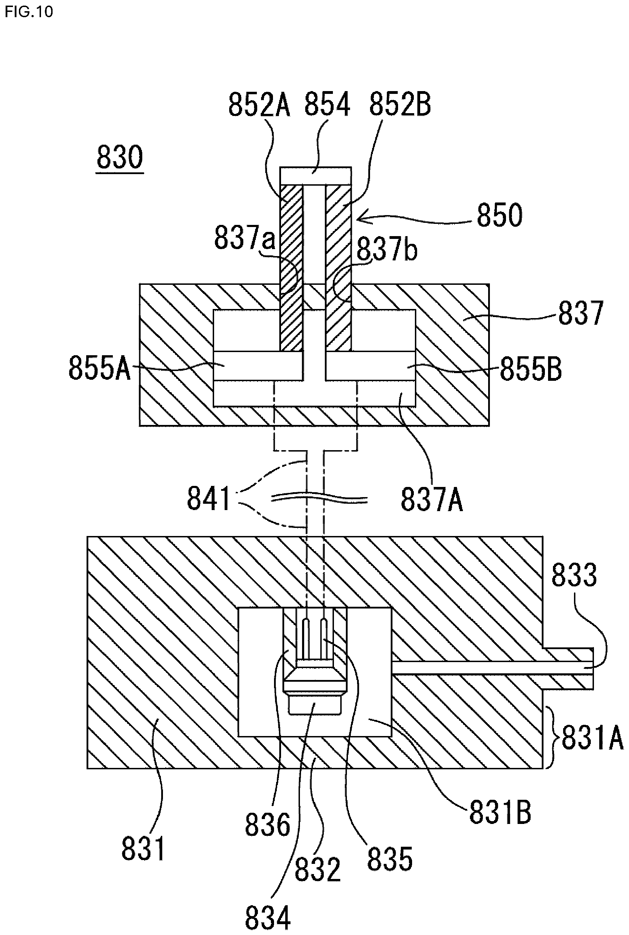

Next, a ninth embodiment of the present invention will be described in detail with reference to FIG. 10. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

As illustrated in FIG. 10, a safety valve 830 is mainly different from the safety valve 730 of the eighth embodiment in that a power generation unit 850 provided separately from a main body 831 is used as a current supply source to an igniter 834. Furthermore, the safety valve 830 is different from the safety valve 30 of the first embodiment in that the power generation unit 850 is used instead of the power supply 40 (battery or the like) of the first embodiment.

The power generation unit 850 includes a first semiconductor 852A, a second semiconductor 852B, conductive members 854, 855A, and 855B, and a box-shaped protection unit 837. The protection unit 837 protects from external heat, and is formed of a material similar to that of the main body 831, a heat resistant material, or the like.

One end portion (outer end portion) of the first semiconductor 852A and one end portion (outer end portion) of the second semiconductor 852B are electrically connected via the conductive member 854. Furthermore, the other end portion of the first semiconductor 852A is electrically connected to one terminal pin 835 via the conductive member 855A and one wiring 841. Furthermore, the other end portion of the second semiconductor 852B is electrically connected to the other terminal pin 835 via the conductive member 855B and the other wiring 841. Each of the conductive member 855A and the conductive member 855B is fixed to an inner wall of the protection unit 837 with an adhesive such as resin.

Furthermore, first semiconductor 852A and second semiconductor 852B of power generation unit 850 are provided so as to pass through through holes 837a and 837b provided on an upper side of protection unit 837, respectively. Note that, although not illustrated, the through holes 837a and 837b are closed by first semiconductor 852A, second semiconductor 852B, resin, and the like. Furthermore, the first semiconductor 852A and the second semiconductor 852B are electrically insulated from the through holes 837a and 837b.

Next, an operation of the safety valve 830 in the present embodiment will be described.

Referring to FIG. 10, in a case where the power generation unit 850 is exposed to an abnormally high temperature higher than or equal to a predetermined temperature, a temperature difference occurs between outer portions of the first semiconductor 852A and the second semiconductor 852B and portions on a side of an internal space 837A of the first semiconductor 852A and the second semiconductor 852B, and a current flows from the power generation unit 850 to the igniter 834 via the wiring 841 due to the Seebeck effect, and the igniter 834 is activated. An openable portion 832 is opened (A hole is formed by melting, cleavage, breakage, or the like) by the flame generated by the activation of the igniter 834, and the gas filled in the tank body is discharged to the external environment through a flow path formed by an internal space 831B and a discharge port 833. Note that a filter circuit using a transistor protection circuit, a diode, or the like may be connected between the wiring 841 and the igniter 834 as necessary for the purpose of cutting off a current less than or equal to a certain current value. Accordingly, malfunction in an unintended situation can be prevented.

With the above configuration, the actions and effects similar to those of the first and eighth embodiments can be achieved. Furthermore, since an external power supply such as the power supply 40 is not required, it is possible to reduce the weight of the safety valve 830 as compared with the case of using the safety valve 30 of the first embodiment. Furthermore, even in a state where no current is supplied to control or a sensor such as when a vehicle is stopped, it is possible to detect a fire (detect an abnormality) and safely operate the safety valve.

<Tenth embodiment>

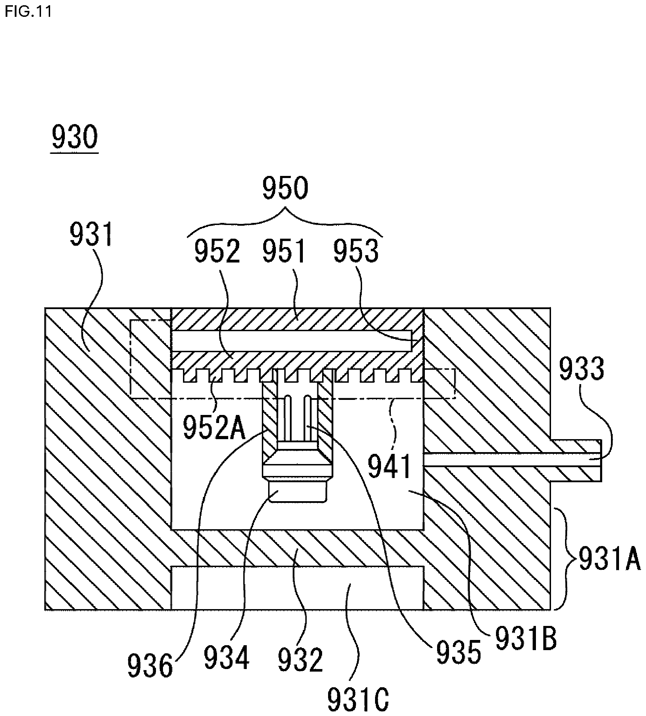

Next, a tenth embodiment of the present invention will be described in detail with reference to FIG. 11. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

As illustrated in FIG. 11, a safety valve 930 is mainly different from the safety valve 30 of the first embodiment in that a power generation unit 950 is used as a current supply source to an igniter 934, a wiring 941 for transmitting a current generated in the power generation unit 950 is provided, and a fixing member 936 is provided on a side of an internal space 931B of the power generation unit 950.

The power generation unit 950 includes a first portion 951 made of the same metal and provided on an outer side, a second portion 952 provided on an inner side so as to face the first portion 951, and a connection portion 953 electrically connecting an end portion of the first portion 951 and an end portion of the second portion 952. Furthermore, the second portion 952 includes a protrusion 952A on the side of the internal space 931B, and the power generation unit 950 is a heat sink.

The internal space 931B is formed by being surrounded by a main body 931 including a recess at a center, and the power generation unit 950 provided to close the recess. Furthermore, the main body 931 and the power generation unit 950 also function as a protection unit that protects the second portion 952 from external heat.

Next, an operation of the safety valve 930 in the present embodiment will be described.

Referring to FIG. 11, in a case where the high-pressure tank is exposed to an abnormally high temperature higher than or equal to a predetermined temperature, a temperature difference occurs between the first portion 951 and the second portion 952, and a current flows from the power generation unit 950 to the igniter 934 via the wiring 941 due to the Seebeck effect, and the igniter 934 is activated. An openable portion 932 is opened (A hole is formed by melting, cleavage, breakage, or the like) by the flame generated by the activation of the igniter 934, and the gas filled in the tank body is discharged to the external environment through a flow path formed by the internal space 931B and a discharge port 933. Note that a filter circuit using a transistor protection circuit, a diode, or the like may be connected between the wiring 941 and the igniter 934 as necessary for the purpose of cutting off a current less than or equal to a certain current value. Accordingly, malfunction in an unintended situation can be prevented.

With the above configuration, the actions and effects similar to those of the first embodiment can be achieved. Furthermore, since an external power supply such as the power supply 40 is not required, it is possible to reduce the weight of the safety valve 930 as compared with the case of using the safety valve 30 of the first embodiment. Furthermore, even in a state where no current is supplied to control or a sensor such as when a vehicle is stopped, it is possible to detect a fire (detect an abnormality) and safely operate the safety valve.

<Eleventh embodiment>

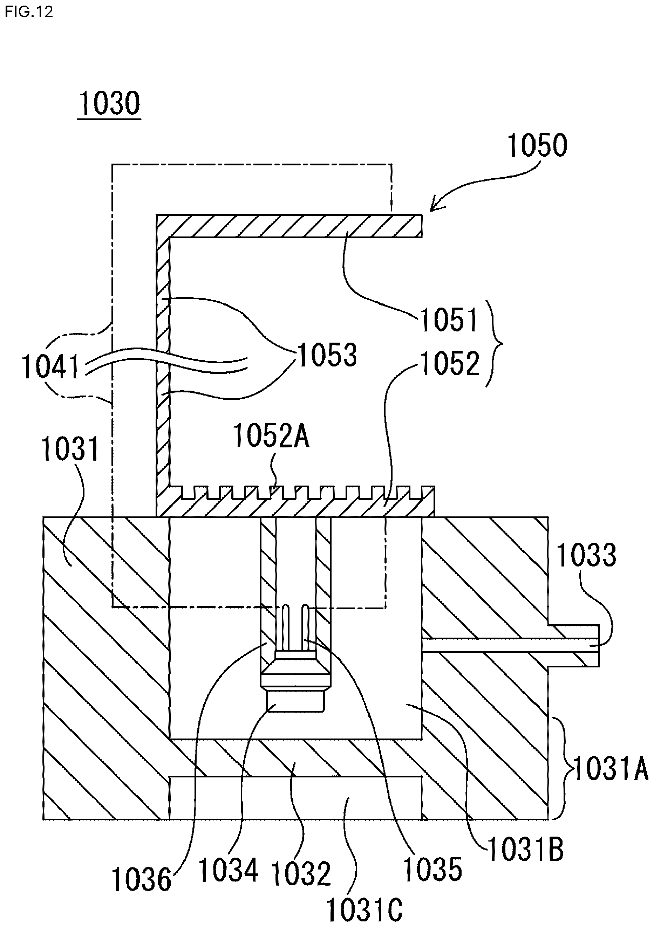

Next, an eleventh embodiment of the present invention will be described in detail with reference to FIG. 12. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

As illustrated in FIG. 11, a safety valve 1030 is mainly different from the safety valve 30 of the first embodiment in that a power generation unit 1050 is used as a current supply source to an igniter 1034, a wiring 1041 for transmitting a current generated in the power generation unit 1050 is provided, and a fixing member 936 is provided on a side of an internal space 1031B of the power generation unit 1050. Furthermore, as illustrated in FIG. 11, the safety valve 1030 is mainly different from the safety valve 930 of the tenth embodiment in that the power generation unit 850 including a portion (first portion 1051 to be described later) provided apart from a main body 1031 is used as a current supply source to the igniter 1034.

The power generation unit 1050 is made of the same metal, and includes the first portion 1051, a second portion 1052, and a connection portion 1053. The first portion 1051 is provided apart from the main body 1031, and the second portion 1052 is electrically connected to the first portion 1051 via the connection portion 1053. Furthermore, the second portion 1052 includes a protrusion 1052A on an outer side, and the power generation unit 1050 is a heat sink. Note that the protrusion 1052A may be provided on an inner side of the main body 1031.

The internal space 1031B is formed by being surrounded by the main body 1031 including a recess at a center, and the second portion 1052 of the power generation unit 1050 provided to close the recess. Furthermore, the fixing member 1036 is provided on a side of the igniter 1034 of the second portion 1052 and supports the igniter 1034.

Next, an operation of the safety valve 1030 in the present embodiment will be described.

Referring to FIG. 12, in a case where the first portion 1051 is exposed to an abnormally high temperature higher than or equal to a predetermined temperature, a temperature difference occurs between the first portion 1051 and the second portion 1052, and a current flows from the power generation unit 1050 to the igniter 1034 via the wiring 1041 due to the Seebeck effect, and the igniter 1034 is activated. An openable portion 1032 is opened (a hole is formed by melting, cleavage, breakage, or the like) by the flame generated by the activation of the igniter 1034, and the gas filled in the tank body is discharged to the external environment through a flow path formed by the internal space 1031B and a discharge port 1033. Note that a filter circuit using a transistor protection circuit, a diode, or the like may be connected between the wiring 1041 and the igniter 1034 as necessary for the purpose of cutting off a current less than or equal to a certain current value. Accordingly, malfunction in an unintended situation can be prevented.

With the above configuration, the actions and effects similar to those of the first embodiment can be achieved. Furthermore, since an external power supply such as the power supply 40 is not required, it is possible to reduce the weight of the safety valve 1030 as compared with the case of using the safety valve 30 of the first embodiment. Furthermore, even in a state where no current is supplied to control or a sensor such as when a vehicle is stopped, it is possible to detect a fire (detect an abnormality) and safely operate the safety valve.

<Twelfth embodiment>

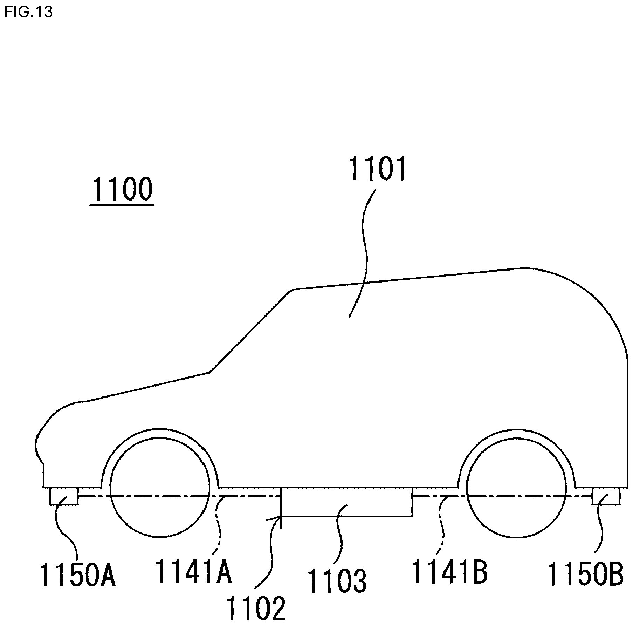

Next, a twelfth embodiment of the present invention will be described in detail with reference to FIG. 13. Note that, since the high-pressure tank of the present embodiment is substantially similar to that of the first embodiment, the description and illustration of the similar parts are omitted unless otherwise specified. Furthermore, the last two digits of the reference signs in the present embodiment and the reference signs in the above embodiment are similar unless otherwise specified, and thus the description thereof will be omitted.

A vehicle 1100 includes a vehicle body 1101 and a high-pressure tank 1102 attached to a central portion of a lower portion of the vehicle body 1101. The high-pressure tank 1102 includes a tank body 1103. Although not illustrated, the tank body 1103 is provided with a plurality of safety valves similar to the safety valve 830 illustrated in the ninth embodiment or the safety valve 1030 illustrated in the eleventh embodiment.

Each of the safety valves includes an igniter (not illustrated), power generation units 1150A and 1150B, and wirings 1141A and 1141B. The power generation unit 1150A is provided in a front portion of a lower portion of the vehicle body 1101, and the power generation unit 1150B is provided in a rear portion of the lower portion of the vehicle body 1101. Furthermore, similarly to the case of the safety valve 830 or the safety valve 1030, the power generation units 1150A and 1150B are electrically connected to the igniter via the wirings 1141A and 1141B. That is, the power generation units 1150A and 1150B are provided apart from a main body and the like of the safety valve.

Next, an operation of the safety valve in the present embodiment will be described.

Referring to FIG. 13, in a case where the power generation unit 1150A or the power generation unit 1150B is exposed to an abnormal high temperature higher than or equal to a predetermined temperature, a temperature difference occurs between the first portion 1051 and the second portion 1052, and a current flows from the power generation unit 1050 to the igniter 1034 via the wiring 1041 due to the Seebeck effect, and the igniter 1034 is activated. An openable portion 1032 is opened (a hole is formed by melting, cleavage, breakage, or the like) by the flame generated by the activation of the igniter 1034, and the gas filled in the tank body is discharged to the external environment through a flow path formed by the internal space 1031B and a discharge port 1033.

With the above configuration, the actions and effects similar to those of the first embodiment can be achieved. Furthermore, since an external power supply such as the power supply 40 is not required, it is possible to reduce the weight of the safety valve 1030 as compared with the case of using the safety valve 30 of the first embodiment. Furthermore, even in a state where no current is supplied to control or a sensor such as when a vehicle is stopped, it is possible to detect a fire (detect an abnormality) and safely operate the safety valve.

Note that, in addition to the power generation units 1150A and 1150B, another power generation unit similar to the power generation units 1150A and 1150B may be provided at an arbitrary location of the vehicle body, and the other power generation unit may be electrically connected to the igniter via a wiring.

Although the embodiments of the present invention have been described above, it is merely an example, and the present invention is not particularly limited, and the specific configuration and the like can be modified in design as appropriate. Furthermore, the actions and effects described in the embodiments of the present invention merely enumerate the most suitable actions and effects resulting from the present invention, and the actions and effects according to the present invention are not limited to those described in the embodiments of the present invention.

For example, in a case where the gas discharged from the discharge port of the safety valve of each embodiment is flammable gas, the gas is preferably discharged toward the ground side. Therefore, a pipe or the like that regulates a discharge direction of the gas discharged from the safety valve to the ground side may be appropriately provided in the discharge port. However, in particular, in the case of a gas that does not ignite, the discharge port may be provided to face in an appropriate direction as long as the human body or the like is not affected.

Furthermore, the second member 231b and the third member 231c in the third embodiment may be formed of a material (for example, an alloy of a metal obtained by combining two or more of lead, tin, bismuth, indium, and antimony) which is soluble when an ambient temperature of the high-pressure tank becomes high temperature (abnormally high temperature) due to an external fire or the like. As a result, in a case where a fire occurs outside and heat is conducted, the second member 231b and the third member 231c are in a fragile state, and the openable portions 232A and 232B are easily opened (cleaved or broken) at the time of activation of the safety valve 230. At this time, the openable portions 232A and 232B can be opened with a smaller amount of the ignition charge 234A than in the case of the third embodiment.

Furthermore, in each of the above embodiments, the safety valve is activated at the time of abnormally high temperature, but the activation of the safety valve is not limited thereto. The activation of each safety valve may be based on a command signal from an electronic control unit (ECU) generated when an abnormality is detected by a sensor or the like. For example, each safety valve may be activated by a command signal output from the ECU in a case where a collision is detected by a sensor or the like.

Furthermore, as the shape of the power generation unit (in particular, the shape of the power generation unit formed of one kind of metal) that generates power by the Seebeck effect of the above-described embodiments and modifications, various shapes such as a layered shape, a plate shape, a rod shape, a linear shape, and a combination of these shapes can be adopted.

Furthermore, in the tenth and eleventh embodiments, the power generation unit is formed of one kind of metal, but the power generation unit is not limited thereto.

For example, a power generation unit using metals having different Seebeck coefficients for the first portion and the second portion may be used.

Furthermore, the respective parts of the above embodiments and modifications may be appropriately combined as necessary.

REFERENCE SIGNS LIST

10, 110, 210, 1103 tank body
10a space
11, 12, 112, 212 opening
20 valve
21 supply port
30, 130, 230, 330, 430, 530, 630, 730, 830, 930, 1030 safety valve
31, 131, 231, 331, 431, 531, 631, 731, 831, 931, 1031 main body
31A, 131A, 231A, 331A, 431A, 531A, 631A, 731A, 831A, 931A, 1031A male screw portion
31B, 131B, 331B, 431B, 531B, 631B, 731B, 831B, 837A, 931B, 1031B internal space
31C, 131C, 231C, 331C, 431C, 531C, 631C, 931C, 1031C bore
32, 132, 232A, 232B, 332, 432, 532, 632, 732, 832, 932, 1032 openable portion
33, 133, 233, 333, 433, 533, 633, 733, 833, 933, 1033 discharge port
34, 134, 334, 534, 634, 734, 834, 934, 1034 igniter
35, 135, 335, 535, 635, 735, 835, 935, 1035 terminal pin
36, 136, 336, 536, 736, 836, 936, 1036 fixing member
40 power supply
41, 141, 341, 541, 641, 741, 841, 941, 1041, 1141A, 1141B wiring
234B, 434B AI agent
100, 1102 high-pressure tank
132a, 532a hole
137, 237, 650 seal member
231B1, 231B2, 231C1, 231C2 recess
231a first member
231b second member
231c third member
234, 434 opening means
234A ignition charge
238 filter
350, 750, 850, 950, 1050, 1150A, 1150B power generation unit
351 first metal layer
352 semiconductor layer
353 second metal layer
434A plate-shaped pedestal
434C pin member
536a cylinder portion
539, 639 piston member
651, 737a, 737b, 837a, 837b through hole
737 lid portion
752A, 852A first semiconductor

752B, 852B second semiconductor
754, 755A, 755B, 855A, 855B conductive member
837 protection unit
951, 1051 first portion
952, 1052 second portion
953, 1053 connection portion
1100 vehicle
1101 vehicle body

**Claims**

1. A safety valve for a high-pressure tank that can be connected to an opening of a tank body filled with a fluid inside, the safety valve comprising:

   a main body including a discharge port that comes into contact with an external environment, and a flow path that allows the opening and the external environment to communicate with each other via the discharge port; and
   a valve that is provided at any position of the flow path, closes the flow path at a normal time, and opens the flow path at a time of abnormally high temperature or abnormality detection,
   wherein a total opening area of the discharge port is 0.008 to 5.5 (mm$^2$).

2. The safety valve for a high-pressure tank according to claim 1, wherein

   the valve includes an openable portion that is opened by driving of an opening means provided in the flow path, and
   the opening means is provided downstream of the openable portion in the flow path, and opens the openable portion using energy obtained by ignition of an explosive as a drive source.

3. The safety valve for a high-pressure tank according to claim 2, wherein

   the opening means is an igniter that is activated by a flow of a current as the explosive, and
   the openable portion includes: a cylinder provided in a direction intersecting the flow path; and a piston member that is slidably provided in the cylinder, closes the flow path in an initial state, and slides by a pressure wave obtained by ignition of the igniter when the igniter is activated to open the flow path.

4. The safety valve for a high-pressure tank according to claim 2, wherein

   the openable portion is a plate-shaped member that closes the flow path, and
   the plate-shaped member is melted, broken, or cleaved by energy obtained by ignition of the explosive.

5. The safety valve for a high-pressure tank according to claim 2 or 3, wherein the opening means further includes an auto-ignition agent that automatically ignites at a predetermined temperature or higher that is lower than an ignition temperature of the explosive to ignite the explosive.

6. The safety valve for a high-pressure tank according to claim 2, wherein the openable portion is formed of a metal soluble at the time of the abnormally high temperature.

7. The safety valve for a high-pressure tank according to claim 2, further comprising:

   a power generation unit that generates power by a Seebeck effect in a case where a temperature difference occurs at a predetermined location; and
   a wiring that electrically connects an igniter that is activated by a flow of a current as the explosive and the power generation unit.

8. The safety valve for a high-pressure tank according to claim 7, wherein

   the power generation unit is formed by layering two or more kinds of materials having different Seebeck coefficients among a metal and a semiconductor in layers, and

one side of a layer stack of the power generation unit is protected from heat by a protection unit such that a temperature gradient occurs in a layering direction in the power generation unit at the time of the abnormally high temperature.

9. The safety valve for a high-pressure tank according to claim 7, wherein

the power generation unit is formed by electrically connecting one end portion of a first semiconductor and one end portion of a second semiconductor having a Seebeck coefficient different from a Seebeck coefficient of the first semiconductor in series,
a protection unit that protects internally a side of another end portion of each of the first semiconductor and the second semiconductor from heat such that a temperature gradient occurs between a side of the one end portion and the side of the other end portion of each of the first semiconductor and the second semiconductor at the time of the abnormally high temperature, and
the side of the other end portion of each of the first semiconductor and the second semiconductor is electrically connected to the igniter via the wiring.

10. The safety valve for a high-pressure tank according to claim 7, wherein the power generation unit is formed of one kind of metal, and is disposed such that a temperature gradient occurs between a part and a part different from the part at the time of the abnormally high temperature.

11. The safety valve for a high-pressure tank according to claim 7, wherein

the power generation unit includes at least a first metal member and a second metal member having a Seebeck coefficient different from a Seebeck coefficient of the first metal member, and is formed by electrically connecting one end portion of the first metal member and one end portion of the second metal member, and
sides of other end portions of the first metal member and the second metal member are electrically connected to the igniter via the wiring, and disposed such that a temperature gradient occurs between both the end portions.

12. The safety valve for a high-pressure tank according to claim 2, wherein

the opening means includes a moving body including a protrusion that is fired toward the openable portion by a pressure wave obtained by ignition of the explosive, and
when activated, breaks or cleaves the openable portion with the protrusion of the moving body to open the openable portion.

FIG.1

FIG.2

FIG.3

(a)

(b)

FIG.4

FIG.5

FIG.6

430

434

431

434B 434C 434A

433

431B

431A

432

431C

FIG.7

(a)

(b)

FIG.8

FIG.9

FIG.10

FIG.11

FIG.12

1030

1050

1051
1052

1041

1053

1031

1052A

1033

1031A

1031B

1036  1034  1032  1035

1031C

FIG.13

1100

1101

1150A  1141A  1103  1141B  1150B

1102

## INTERNATIONAL SEARCH REPORT

| International application No. |
| --- |
| **PCT/JP2023/006326** |

### A. CLASSIFICATION OF SUBJECT MATTER

*F16K 17/38*(2006.01)i; *F16K 17/40*(2006.01)i
FI: F16K17/38 Z; F16K17/40 A; F16K17/38 A

According to International Patent Classification (IPC) or to both national classification and IPC

### B. FIELDS SEARCHED

Minimum documentation searched (classification system followed by classification symbols)

F16K17/38; F16K17/40

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 2014-185713 A (TOYOTA MOTOR CORP) 02 October 2014 (2014-10-02) paragraphs [0008], [0017]-[0018], fig. 1-2 | 1 |
| Y | | 2-12 |
| Y | US 6412512 B1 (GIAT INDUSTRIES) 02 July 2002 (2002-07-02) column 3, lines 45-49, fig. 1-4 | 2-12 |
| Y | JP 2007-112180 A (MAZDA MOTOR CORP) 10 May 2007 (2007-05-10) paragraph [0024], fig. 1-3 | 6 |
| Y | JP 2013-76433 A (HONDA MOTOR CO LTD) 25 April 2013 (2013-04-25) paragraphs [0044]-[0046], [0055], [0059]-[0061], fig. 1-9 | 7-11 |
| A | JP 5007809 B2 (TOYOTA MOTOR CORP) 22 August 2012 (2012-08-22) | 1-12 |

☐ Further documents are listed in the continuation of Box C.  ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **07 April 2023** | **25 April 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/006326**

| Patent document cited in search report | | | Publication date (day/month/year) | Patent family member(s) | | | Publication date (day/month/year) |
|---|---|---|---|---|---|---|---|
| JP | 2014-185713 | A | 02 October 2014 | (Family: none) | | | |
| US | 6412512 | B1 | 02 July 2002 | WO | 2001/001026 | A1 | |
| | | | | EP | 1108173 | A1 | |
| | | | | FR | 2795477 | A1 | |
| | | | | ES | 2223557 | T3 | |
| JP | 2007-112180 | A | 10 May 2007 | (Family: none) | | | |
| JP | 2013-76433 | A | 25 April 2013 | (Family: none) | | | |
| JP | 5007809 | B2 | 22 August 2012 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5007809 B